(19) Europäisches Patentamt
European Patent Office
Office européen des brevets

(11) **EP 3 544 128 A1**

(12) **EUROPEAN PATENT APPLICATION**
published in accordance with Art. 153(4) EPC

(43) Date of publication:
**25.09.2019 Bulletin 2019/39**

(51) Int Cl.:
**H01S 5/022** *(2006.01)*  **G02B 6/42** *(2006.01)*
**H01S 5/40** *(2006.01)*

(21) Application number: **17872110.6**

(22) Date of filing: **16.11.2017**

(86) International application number:
**PCT/JP2017/041308**

(87) International publication number:
**WO 2018/092850 (24.05.2018 Gazette 2018/21)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **16.11.2016 JP 2016223351**

(71) Applicant: **Fujikura Ltd.**
**Tokyo 135-8512 (JP)**

(72) Inventor: **KATAGIRI, Ken**
**Sakura-shi**
**Chiba 285-8550 (JP)**

(74) Representative: **Cabinet Plasseraud**
**66, rue de la Chaussée d'Antin**
**75440 Paris Cedex 09 (FR)**

(54) **LASER MODULE**

(57) An embodiment of the present invention provides a laser module having a longer average device life as compared to a conventional laser module. A laser module (1) includes: a plurality of laser diodes (LD1 to LD6) emitting laser beams; and an optical fiber (OF), the laser beams being caused to enter the optical fiber (OF), the laser diodes (LD1 to LD6) being arranged such that among light beams constituting return light emitted from the optical fiber (OF), a paraxial beam does not meet active layers of the laser diodes (LDi) at respective exit end surfaces of the laser diodes (LDi), the paraxial beam having been emitted from the optical fiber (OF) at an emission angle θ of not more than θ1 which is given by the following Formula (A):
[Math. 1]

$$\theta_1 = \frac{\text{Arcsin}(NA)}{3}\sqrt{2\ln 2} \quad \dots \ (A),$$

where NA is a numerical aperture of the optical fiber.

FIG. 1

## Description

Technical Field

The present invention relates to a laser module including a plurality of laser diodes and an optical fiber.

Background Art

A laser module including a plurality of laser diodes and an optical fiber is widely used as an excitation light source of a fiber laser. In such a laser module, laser beams emitted from the plurality of laser diodes are caused to enter the optical fiber. Use of the laser module makes it possible to obtain a high-power laser beam which cannot be obtained from a single laser diode.

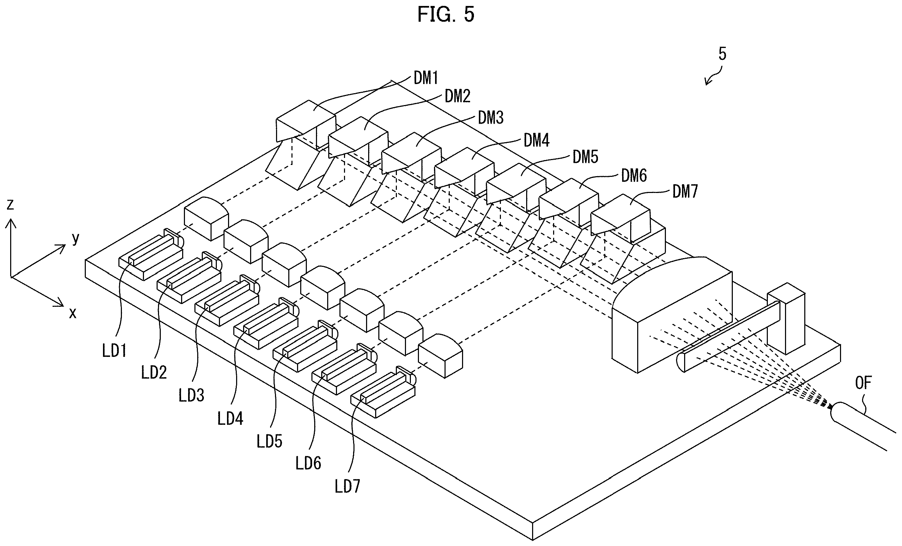

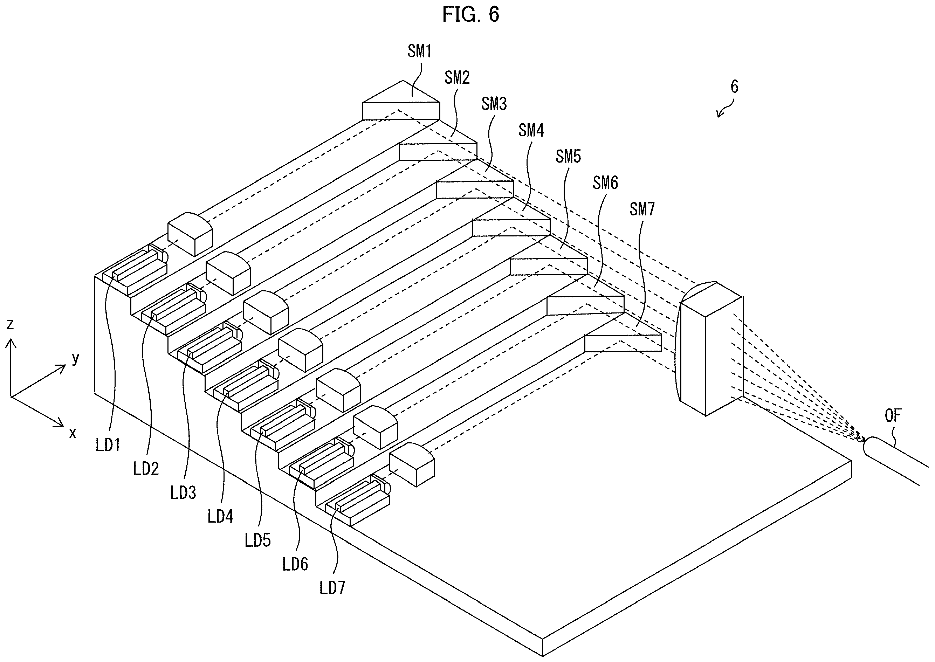

Typical examples of conventional laser modules encompass a laser module 5 (see Patent Literature 1) illustrated in Fig. 5 and a laser module 6 (see Patent Literature 2) illustrated in Fig. 6. In the laser module 5 illustrated in Fig. 5, laser beams emitted from seven laser diodes LD1 to LD7 are guided to an optical fiber OF by use of seven double mirrors DM1 to DM7. On the other hand, in the laser module 6 illustrated in Fig. 6, laser beams emitted from seven laser diodes LD1 to LD7 are guided to an optical fiber OF by use of seven single mirrors SM1 to SM7. Both of the above laser modules 5 and 6 can provide a laser beam whose power is approximately seven times as strong as a laser beam emitted from each of the laser diodes.

Citation List

[Patent Literature]

[Patent Literature 1] Japanese Patent No. 5717714 (Registration Date: March 27, 2015)
[Patent Literature 2] Japanese Patent Application Publication, *Tokukai,* No. 2013-235943 (Publication Date: November 21, 2013)

Summary of Invention

Technical Problem

However, the inventor of the present application has found that in the conventional laser modules 5 and 6, a failure occurrence rate of a laser diode LD4 in the center is high and this may result in a problem of a shortened average device life. Further, the inventor of the present application has found that such a problem is caused by return light which occurs when the laser module 5 or 6 is connected to a fiber laser.

In other words, a laser beam emitted from the laser module 5 or 6 is utilized, in a fiber laser, for excitation of a rare-earth element which has been added to an amplifying optical fiber. However, a remaining laser beam, which has not been utilized for excitation of the rare-earth element, re-enters the laser module 5 or 6 as return light. Further, part of a laser beam, which occurs in stimulated emission from the rare-earth element in the amplifying optical fiber, also enters the laser module 5 or 6 as return light. Furthermore, in a case where a laser beam emitted from a fiber laser is reflected by an object to be processed, light thus reflected also enters the laser module 5 or 6 as return light. In addition, in a case where a Stokes beam produced by stimulated Raman scattering due to the laser beam mentioned above may also enter the laser module 5 or 6 as return light.

In the laser module 5 or 6, the return light described above exits from the optical fiber OF and enters the laser diodes LD1 to LD7. The return light emitted from the optical fiber OF is a Gaussian beam. Accordingly, the intensity of return light which enters the laser diode LD4 in the center is higher than the intensity of return light which enters the other laser diodes LD1 to LD3, and LD5 to LD7. This leads to a high failure occurrence rate of the laser diode LD4 in the center and consequently results in a shortened average device life of the laser module 5 or 6. In particular, in the case of the laser beam which occurs in stimulated emission from the rare-earth element in the amplifying optical fiber, laser beam propagation angles are distributed within a narrow angle range. This tends to be a cause of an increase in failure occurrence rate of the laser diode LD4 in the center.

The present invention is attained in view of the above problems. An object of the present invention is to provide a laser module whose average device life is longer than that of a conventional laser module.

Solution to Problem

In order to solve the above problem, a laser module in accordance with an embodiment of the present invention includes: a plurality of laser diodes emitting laser beams; and an optical fiber, the laser beams being caused to enter the optical fiber, the laser diodes being arranged such that among light beams constituting return light emitted from the optical fiber, a paraxial beam does not meet active layers of the laser diodes at respective exit end surfaces of the laser diodes, the paraxial beam having been emitted from the optical fiber at an emission angle θ of not more than θ1 which is given by the following Formula (A):
[Math. 1]

$$\theta_1 = \frac{\text{Arcsin}(NA)}{3}\sqrt{2\ln 2} \quad \cdots \ (A),$$

where NA is a numerical aperture of the optical fiber.
In order to solve the above problem, a laser module in accordance with an embodiment of the present invention includes: 2M - 1 laser diodes emitting laser beams, where M is a natural number of not less than 2; and an optical fiber, the laser beams being caused to enter the optical fiber, the 2M - 1 laser diodes being spatially clustered such that among light beams constituting return light emitted from the optical fiber, a light beam on an optical axis does not meet active layers of the 2M - 1 laser diodes at respective exit end surfaces of the 2M - 1 laser diodes, the light beam on the optical axis being emitted at an emission angle of 0°, the 2M - 1 laser diodes being arranged such that the respective exit end surfaces of the 2M - 1 laser diodes are provided at 2M - 1 points $x_1$, $x_2$,..., $x_M$, and $x_{N-M+2}$, $X_{N-M+3}$,..., $x_N$ selected from among N points $x_1$, $x_2$,..., $x_N$, where N is a natural number of not less than 2M + 1, the N points $x_1$, $x_2$,..., $x_N$ being provided at equal intervals on a certain line segment or a certain circular arc and arranged such that a relation of optical path lengths $L_j$ from respective points $x_j$ to an entrance end surface of the optical fiber is $L1 > L_2 > ... > L_N$.

Advantageous Effects of Invention

An embodiment of the present invention makes it possible to provide a laser module whose average device life is longer than that of a conventional laser module.

Brief Description of Drawings

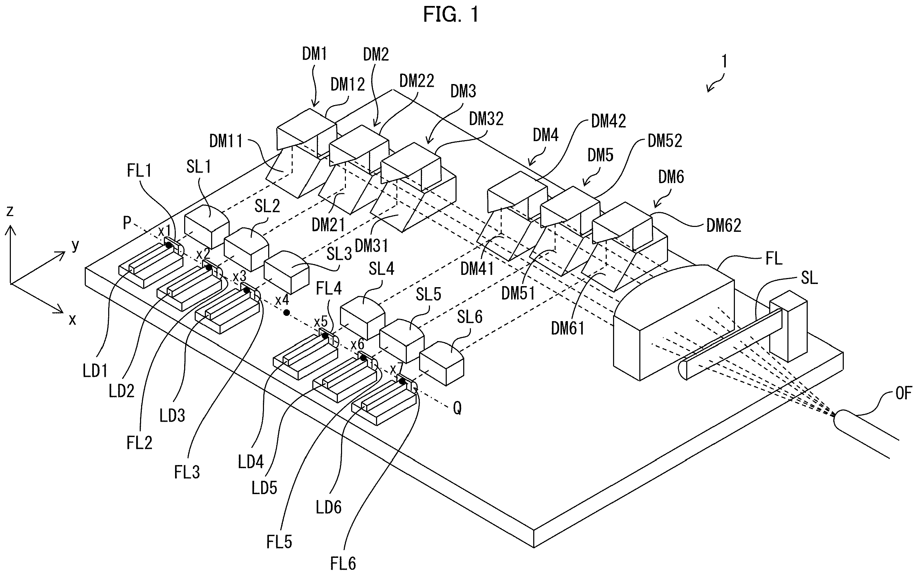

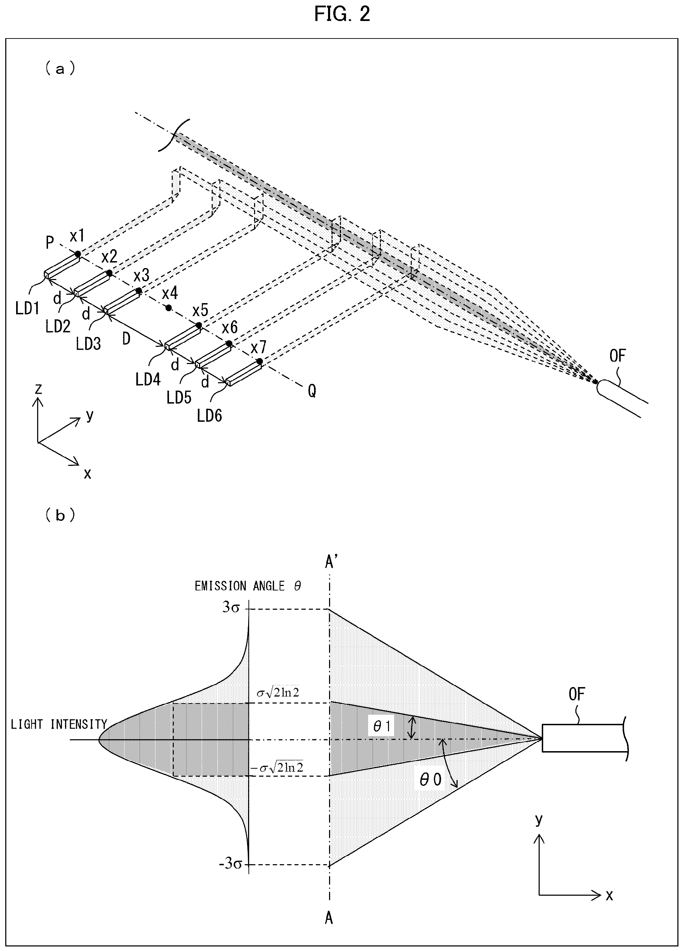

Fig. 1 is a perspective view illustrating a laser module in accordance with Embodiment 1 of the present invention.
(a) of Fig. 2 is a perspective view illustrating laser diodes and an optical fiber, which are provided in the laser module illustrated in Fig. 1, together with return light emitted from the optical fiber. (b) of Fig. 2 is a graph showing a beam profile of the return light emitted from the optical fiber.
Fig. 3 is a perspective view illustrating a Variation of the laser module illustrated in Fig. 1.
Fig. 4 is a perspective view illustrating a laser module in accordance with Embodiment 2 of the present invention.
Fig. 5 is a perspective view illustrating a conventional laser module.
Fig. 6 is a perspective view illustrating a conventional laser module.

Description of Embodiments

[Embodiment 1]

(Configuration of laser module)

The following will discuss a configuration of a laser module 1 in accordance with Embodiment 1 of the present invention, with reference to Fig. 1. Fig. 1 is a perspective view illustrating a configuration of a laser module 1 in accordance with Embodiment 1.

The laser module 1 includes six laser diodes LD1 to LD6, six F-axis collimating lenses FL1 to FL6, six S-axis collimating lenses SL1 to SL6, six double mirrors DM1 to DM6, an F-axis light condensing lens FL, an S-axis light condensing lens, and an optical fiber OF, as illustrated in Fig. 1. The laser diodes LD1 to LD6, the F-axis collimating lenses FL1 to FL6, the S-axis collimating lenses SL1 to SL6, the double mirrors DM1 to DM6, the F-axis light condensing lens FL, and the S-axis light condensing lens SL are mounted on a bottom plate of a housing of the laser module 1. The optical fiber OF passes through a side wall of the housing of the laser module 1 such that an end portion including an entrance end surface of the optical fiber OF extends into the housing of the laser module 1.

A laser diode LDi (where i is a natural number of not less than 1 and not more than 6) is a light source which emits a laser beam. In Embodiment 1, the laser diode LDi is a laser diode which is arranged such that in a coordinate system illustrated in Fig. 1, an active layer is parallel to an xy plane and an exit end surface is parallel to a zx plane. A laser beam emitted from the laser diode LDi travels in a direction (traveling direction) corresponding to a positive direction of a y axis. The laser beam has a Fast axis (F axis) parallel to a z axis and a Slow axis (S axis) parallel to an x axis. The laser diodes LD1 to LD6 are arranged such that respective exit end surfaces of these laser diodes LDi are aligned on line L parallel to the x axis. Then, optical axes of respective laser beams emitted from the laser diodes LD1 to LD6 are parallel to one another in a plane parallel to the xy plane.

An F-axis collimating lens FLi is provided in an optical path of a laser beam emitted from the laser diode LDi. In Embodiment 1, the F-axis collimating lenses FL1 to FL6 are each a plano-convex cylindrical lens which is arranged such that in the coordinate system shown in Fig. 1, a flat surface (entrance face) faces in a negative direction of the y axis and a curved surface (exit face) faces in the positive direction of the y axis. The F-axis collimating lens FLi is arranged so as to have an arc-like outer edge of a cross section parallel to a yz plane on a positive side along the y axis. Then, the F-axis collimating lens FLi collimates the laser beam diverging in an F-axis direction, which laser beam has been emitted from the laser diode LDi.

In an optical path of the laser beam having passed through the F-axis collimating lens FLi, an S-axis collimating lens is provided. In Embodiment 1, the S-axis collimating lenses SL1 to SL6 are each a plano-convex cylindrical lens which is arranged such that in the coordinate system shown in Fig. 1, a flat surface (entrance face) faces in the negative direction of the y axis and a curved surface (exit face) faces in the positive direction of the y axis. The S-axis collimating lens SLi is provided so as to have an arc-like outer edge of a cross section parallel to the xy plane on a positive side along the y axis.

Then, the S-axis collimating lens SLi collimates the laser beam diverging in an S-axis direction, which laser beam has been emitted from the laser diode LDi and passed through the F-axis collimating lens FLi.

In an optical path of the laser beam having passed through the S-axis collimating lens SLi, a double mirror DMi is provided. The double mirror DMi is mounted on the bottom plate of the housing of the laser module 1. The double mirror DMi includes: a first mirror DMi1 whose lower surface is adhesively fixed to an upper surface of the bottom plate of the housing; and a second mirror DMi2 whose lower surface is adhesively fixed to an upper surface of the first mirror DMi1. The first mirror DMi1 has a reflective surface whose normal vector makes an angle of 45° with respect to a positive direction of the z axis. The first mirror DMi1 reflects a laser beam emitted from the LD chip LDi so as to convert the traveling direction of the laser beam from the positive direction of the y axis to the positive direction of the z axis and also to convert the laser beam from a state in which the F axis is parallel to the z axis to a state in which the F axis is parallel to the y axis. The second mirror DMi2 has a reflective surface whose normal vector makes an angle of 135° with respect to the positive direction of the z axis. The second mirror DMi2 reflects the laser beam having been reflected by the first mirror DMi1 so as to convert the traveling direction of the laser beam from the positive direction of the z axis to a positive direction of the x axis and also to convert the laser beam from a state in which the S axis is parallel to the x axis to a state in which the S axis is parallel to the z axis. The double mirrors DM1 to DM6 are arranged such that the relation of optical path lengths li from the laser diodes LDi to respectively corresponding double mirrors DMi is: 11 < 12 < 13 < 14 < 15 < 16. Then, respective optical axes of laser beams having been reflected by second mirrors DM12 to DM62 are parallel to one another in a plane parallel to the xy plane.

In optical paths of the laser beams having been reflected by the second mirrors DM12 to DM62, the F-axis light condensing lens FL is provided. In Embodiment 1, the F-axis light condensing lens FL is a plano-convex cylindrical lens which is arranged such that in the coordinate system shown in Fig. 1, a curved surface (exit face) faces in a negative direction of the x axis and a flat surface (entrance face) faces in the positive direction of the x axis. The F-axis light condensing lens FL is arranged so as to have an arc-like outer edge of a cross section parallel to the xy plane on a negative side along the x axis. Then, the F-axis light condensing lens FL (i) collects the laser beams, which have been reflected by the second mirrors DM12 to DM62, so that the optical axes of these laser beams intersect with one another at one point and at the same time, (ii) condenses each of the laser beams so that an F-axis diameter of each of the laser beams reduces.

In an optical path of the laser beams having passed through the F-axis light condensing lens FL, the S-axis light condensing lens is provided. In Embodiment 1, the S-axis light condensing lens SL is a plano-convex cylindrical lens which is arranged such that in the coordinate system shown in Fig. 1, a curved surface (exit face) faces in the negative direction of the x axis and a flat surface (entrance face) faces in the positive direction of the x axis. The S-axis light condensing lens SL is arranged so as to have an arc-like outer edge of a cross section parallel to the yz plane on a negative side along the x axis. Then, the S-axis light condensing lens SL condenses each of the laser beams, which have been collected and each condensed by the F-axis light condensing lens FL, so that an S-axis diameter of each of the laser beams reduces.

At an intersection of the optical axes of the laser beams having passed through the S-axis light condensing lens SL, the entrance end surface of the optical fiber OF is provided. The optical fiber OF is provided such that the entrance end surface faces in the negative direction of the x axis. The laser beams having been condensed by the S-axis light condensing lens SL enter the optical fiber OF via this entrance end surface.

Note that respective traveling directions of the laser beams emitted from the laser diodes LD1 to LD6, respectively, each may independently have an error. In other words, the traveling directions of the laser beams emitted from the laser diodes LD1 to LD6, respectively, may be non-uniformly distributed in a specific angular range with respect to the positive direction of the y axis. Therefore, traveling directions of the laser beams reflected by the second mirrors DM12 to DM62 of the double mirrors DM1 to DM6 each may independently have an error. In other words, the traveling directions of the laser beams reflected by the second mirrors DM12 to DM62 of the double mirrors DM1 to DM6 may be non-uniformly distributed in a specific angular range with respect to the positive direction of the x axis.

Such errors can be corrected by using the double mirrors DM1 to DM6 in a production process of the laser module 1. That is, in each double mirror DMi, the first mirror DMi1 can rotate on the z axis as a rotation axis until the first mirror DMi1 is adhesively fixed to the bottom plate of the housing, while the second mirror DMi2 can rotate on the z axis as a rotation axis until the second mirror DMi2 is adhesively fixed to the first mirror DMi1. Rotation of the first mirror DMi1 causes a change in elevation angle of a traveling direction of the laser beam reflected by the second mirror DMi2. Meanwhile, rotation of the second mirror DMi2 causes a change in azimuth angle of the traveling direction of the laser beam reflected by the second mirror DMi2. Accordingly, it is possible to obtain the laser module 1 whose errors described above are corrected, by (i) rotating the first mirror DMi1 and the second mirror DMi2 so that the traveling direction of the laser beam reflected by the second mirror DMi2 coincides with the positive direction of the x axis and (ii) thereafter, curing an adhesive which has been applied in advance to the lower surface of the first mirror DMi1 and the lower surface of the second mirror DMi2.

Note that though Embodiment 1 employs a configuration in which respective orientations of the laser diodes LD1 to LD6 are set such that optical axes of the laser beams emitted from the laser diodes LD1 to LD6 are parallel to one another, an embodiment of the present invention is not limited to such a configuration. In other words, it is possible to employ an alternative configuration in which the respective orientations of the laser diodes LD1 to LD6 are set such that extended lines of the optical axes of these laser beams intersect with one another at one point. Note also that though Embodiment 1 employs a configuration in which respective orientations of the second mirrors DM12 to DM26 are set such that optical axes of the laser beams reflected by the second mirrors DM12 to DM62 are parallel to one another, an embodiment of the present invention is not limited to such a configuration. In other words, an embodiment of the present invention can employ an alternative configuration in which the respective orientations of the second mirrors DM12 to DM26 are set such that extended lines of the optical axes of these laser beams intersect with one another at one point. When the above alternative configurations are employed, it is possible to shorten a distance between the F-axis light condensing lens FL and an intersection of the optical axes of the laser beams collected by the F-axis light condensing lens FL. This makes it possible to reduce the size of the laser module 1.

In addition, note that though Embodiment 1 employs a configuration in which the laser diodes LD1 to LD6 are arranged such that centers of respective active layers at exit end surfaces of the laser diodes LD1 to LD6 are aligned on a certain line segment, an embodiment of the present invention is not limited to this configuration. In other words, it is possible to employ a configuration in which the laser diodes LD1 to LD6 are arranged such that the centers of the respective active layers at the exit end surfaces of the laser diodes LD1 to LD6 are provided on a certain circular arc. The former configuration is suitable in a case where the optical axes of the laser beams emitted from the laser diodes LD1 to LD6 are parallel to one another, whereas the latter configuration is suitable in a case where the optical axes of the laser beams emitted from the laser diodes LD1 to LD6 intersect with one another at one point.

(Feature of laser module)

The following will discuss a feature of the laser module 1, with reference to Fig. 2. (a) of Fig. 2 is a perspective view illustrating the laser diodes LD1 to LD6 and the optical fiber OF, which are provided in the laser module 1, together with return light emitted from the optical fiber OF, and (b) of Fig. 2 is a graph showing a beam profile of the return light emitted from the optical fiber OF.

The laser module 1 has a feature in the following point: the laser diodes LD1 to LD6 are spatially clustered so that among light beams constituting the return light emitted from the optical fiber OF via the entrance end surface of the optical fiber OF, a light beam on an optical axis (more preferably, paraxial beams) will be prevented from entering the active layer of each laser diode LDi.

The expression that the laser diodes LD1 to LDn are spatially clustered means that on the condition that a certain threshold is present, (1) the laser diodes LD1 to LDn are separated into some groups such that in a case where a distance between adjacent laser diodes (e.g., a distance between centers of respective active layers in exit end surfaces of the adjacent laser diodes) is smaller than the threshold, these adjacent laser diodes belong to one group and (2) a distance between adjacent laser diodes belonging to different groups is longer than the threshold. In a case where the laser diodes LD1 to LDn are separated into groups so as to satisfy the above conditions, each group is referred to as a "cluster". An isolated laser diode (which is apart from adjacent laser diodes on respective side of the isolated later diode by a distance larger than the threshold) forms a cluster alone.

For example, in a case where laser diodes LD1 to LDn aligned on a certain line segment satisfy the condition that "a distance D between adjacent laser diodes LDm and LDm+1 which belong to different clusters is larger than a distance d between adjacent laser diodes LDi and LDi + 1 (i = 1, 2,..., m - 1, m + 1,..., n - 1) which belong to one cluster", the laser diodes LD1 to LDn can be regarded as being clustered into a first cluster including m laser diodes LD1 to LDm and a second cluster including (n-m) laser diodes LDm + 1 to LDn.

In Embodiment 1, the laser diodes LD1 to LD6 are arranged such that the centers of the respective active layers in the exit end surfaces are at six points $x_1$, $x_2$, $x_3$, $x_5$, $x_6$ and $x_7$ excluding the point $x_4$ in the center among seven points $x_1$, $x_2$,..., $x_7$ which are aligned at equal intervals on a line segment PQ. This separates the six laser diodes LD1 to LD6 into the first cluster constituting three laser diodes LD1 to LD3 and the second cluster constituting three laser diodes LD4 to LD6. The distance D between adjacent laser diodes LD3 and LD4 which belong to different clusters is two times as large as the distance d between the adjacent laser diodes LDi and LDi + 1 (i = 1, 2, 4, and 5) which belong to one cluster.

The beam profile of the return light emitted from the optical fiber OF is normally a Gaussian as shown in (b) of Fig. 2 and expressed as a function f(θ) of an emission angle θ defined by the following Formula (1). Therefore, the intensity of the return light emitted from the optical fiber OF is the maximum when the emission angle θ is 0°, and is half the maximum value f(0) when the emission angle $\theta 1 = \sigma(21n2)1/2$. Here, σ is a standard deviation of the beam profile f(θ). On the assumption that a beam divergence angle θ0 = Arcsin(NA), which is determined depending on a numerical aperture NA of the optical fiber OF, corresponds to 3σ of the beam profile f(θ), the following Formula (2) gives an emission angle θ1 at the time when the intensity of the return light is half the maximum value f(0). In a case where the numerical aperture NA of the optical fiber OF is 1.8, the emission angle $\theta 1$, at the time when the intensity of the return light is half the maximum value f(0), is approximately 4.1°.

[Math. 2]

$$f(\theta) = \frac{1}{\sqrt{2\pi\sigma^2}} \exp(-\frac{\theta^2}{2\sigma^2}) \quad \cdots \ (1)$$

[Math. 3]

$$\theta_1 = \frac{\text{Arcsin}(NA)}{3} \sqrt{2\ln 2} \quad \cdots \ (2)$$

The intensity of the return light emitted from the optical fiber OF is thus the maximum in the case of the light beam on the optical axis at an emission angle $\theta$ of 0°. Accordingly, if (a) the threshold is set so that the light beam on the optical axis will be prevented from entering the active layers of the laser diodes LD1 to LD6 and (b) the laser diodes LD1 to LD6 are spatially clustered, it is possible to decrease the maximum intensity of the return light which enters the active layers of the laser diodes LD1 to LD6 (intensity having the highest value among intensities of the return light which enters active layers of laser diodes LDi) as compared to that in a conventional laser module 5 (see Fig. 5). This decreases a maximum failure occurrence rate of the laser diodes LD 1 to LD6 (the highest failure occurrence rate among failure occurrence rates of respective laser diodes LDi) as compared to that in the conventional laser module 5. As a result, the laser module 1 has a longer average device life than the conventional laser module 5. Note that if the laser diodes LD1 to LD6 are arranged such that the light beam on the optical axis of the return light will be prevented from entering the active layers of the laser diodes LD1 to LD6, the above effect can be obtained regardless of whether or not the laser diodes LD1 to LD6 are spatially clustered.

Further, the intensity of the return light emitted from the optical fiber OF is not less than half the maximum value in the case of paraxial beams whose emission angles $\theta$ are not more than $\theta 1$ given by the above Formula (2). Accordingly, if (a) the threshold is set so that these paraxial beams will be prevented from entering the active layers of the laser diodes LD1 to LD6 and (ii) the laser diodes LD1 to LD6 are spatially clustered, it is possible to decrease the maximum intensity of the return light which enters the active layers of the laser diodes LD1 to LD6 to less than half that in the conventional laser module 5 (see Fig. 5). This makes it possible to further decrease the maximum failure occurrence rate of the laser diodes LD1 to LD6 and consequently, to further extend the average device life of the laser module 1. Note that if the laser diodes LD1 to LD6 are arranged such that paraxial beams of the return light will be prevented from entering the active layers of the laser diodes LD1 to LD6, the above effect can be obtained regardless of whether or not the laser diodes LD1 to LD6 are spatially clustered.

Meanwhile, the F-axis light condensing lens FL is preferably a spherical lens. In a case where the F-axis light condensing lens FL is a spherical lens, a degree of collimation of the return light decreases as compared to a case where the F-axis light condensing lens FL is a non-spherical lens. This decreases a light density of the return light which enters the active layers of the laser diodes LD1 to LD6. This makes it possible to further decrease the maximum failure occurrence rate of the active layers of the laser diodes LD1 to LD6 and consequently, to further extend the average device life of the laser module 1.

(Variation)

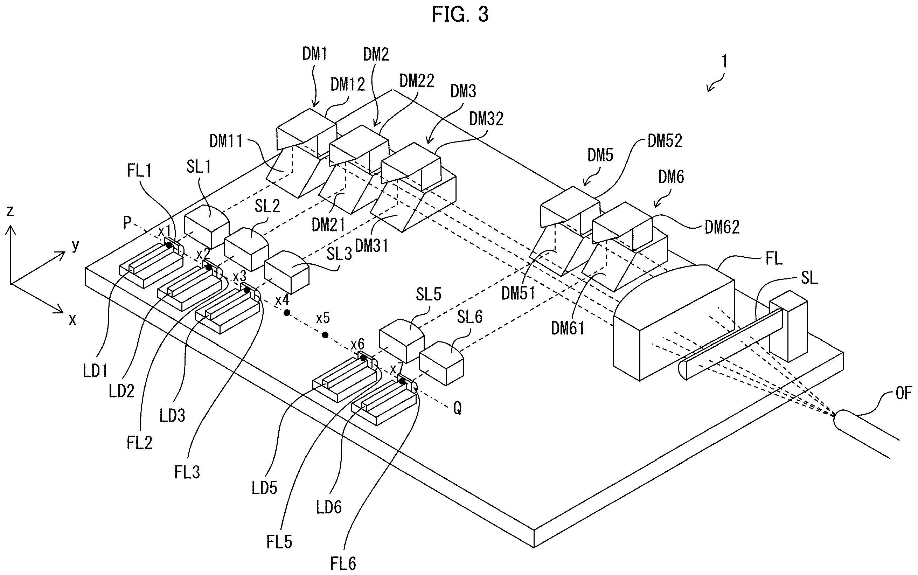

The following will discuss a Variation of the laser module 1, with reference to Fig. 3. Fig. 3 is a perspective view illustrating a configuration of a laser module 1 in accordance with the present Variation.

The module 1 illustrated in Fig. 3 is different from the laser module 1 illustrated in Fig. 1 in that the laser diode LD4, the F-axis collimating lens FL4, the S-axis collimating lens SL4 and the double mirror DM4 are not provided.

In the laser module 1 illustrated in Fig. 3, laser diodes LD1 to LD3, LD5 and LD6 are arranged such that centers of respective active layers at exit end surfaces of the laser diodes LD1 to LD3, LD5 and LD6 are at five points $x_1$, $x_2$, $x_3$, $x_6$ and $x_7$ excluding points $x_4$ and $x_5$ in the vicinity of the center among seven points $x_1$, $x_2$,..., $x_7$ which are aligned at equal intervals on a line segment PQ. This separates these five laser diodes LD1 to LD3, LD5 and LD6 into a first cluster including three laser diodes LD1 to LD3 and a second cluster including two laser diodes LD5 and LD6. The distance D between adjacent laser diodes LD3 and LD5 which belong to different clusters is three times as large as the distance d between adjacent laser diodes LDi and LDi + 1 (i = 1, 2, 4, and 5) which belong to one cluster.

In comparison of respective intensities $P(x_1)$, $P(x_2)$,..., $P(x_7)$ of return light which comes to the seven points $x_1$, $x_2$,..., $x_7$ which are aligned at equal intervals on the line segment PQ, the relation of the intensities $P(x_1)$, $P(x_2)$,..., $P(x_7)$ is such that $P(x_4) > P(x_5) > P(x_3) > P(x_6) > P(x_2) > P(x_7) > P(x_1)$. Here, the intensities are $P(x_4) > P(x_5) > P(x_6) > P(x_7)$ and $P(x_4) > P(x_3) > P(x_2) > P(x_1)$. This is because a light beam having a larger emission angle $\theta$ (i.e., having a lower intensity) comes to a point farther from the point $x_4$ in the center. Meanwhile, $P(x_5)$ is higher than $P(x_3)$. This is because since the optical path length from the entrance end surface of the optical fiber OF to the point $x_5$ is shorter than that to the point $x_3$, a light beam which comes to the point $x_5$ has a higher intensity than a light beam which comes to the point $x_3$. The same is true for $P(x_6) > P(x_2)$ and $P(x_7) > P(x_1)$.

Therefore, in a case where five laser diodes are arranged such that centers of respective active layers in exit end surfaces of the five laser diodes are provided at any five points among seven points $x_1, x_2,..., x_7$ which are aligned at equal intervals on a line segment PQ, it is the best to provide the five laser diodes such that the centers of the respective active layers in the exit end surfaces of the five laser diodes are provided at the points $x_1, x_2, x_3, x_6$, and $x_7$. This is because in such an arrangement, the maximum intensity of return light which enters the five laser diodes can be reduced to be lower than those in other arrangements. In this regard, the arrangement of the laser diodes LD1 to LD3, LD5 and LD6 in the laser module 1 illustrated in Fig. 3 is the best arrangement.

In general, in a case where 2M - 1 (M is an integer of not less than 2) laser diodes are provided such that centers of respective active layers in exit end surfaces of these laser diodes are provided at any points among N points (N is a natural number of not less than 2M + 1) $x_1, x_2,..., x_N$, which are provided at equal intervals on a certain line segment or a certain circular arc and which are arranged such that the relation of optical path lengths Lj from respective points $x_j$ to an entrance end surface of the optical fiber is $L_1 > L_2 >...> L_N$, it is preferable to provide the laser diodes such that the centers of the respective active layers at the exit end surfaces of the laser diodes are provided at points $x_1, x_2,..., x_M$, and $x_{N-M+2}, x_{N-M+3},..., x_N$ as in the laser module 1 illustrated in Fig. 3. This is because the maximum intensity of return light, which enters the 2M - 1 laser diodes, is the lowest in the above arrangement among $_NC_{2M-1}$ arrangements in which centers of respective active layers in exit end surfaces of laser diodes are provided at 2M - 1 points selected from N points $x_1, x_2,..., x_N$.

Note that in a case where 2M (M is an integer of not less than 2) laser diodes are provided such that centers of respective exit end surfaces of these laser diodes are provided at any points among N points (N is a natural number of not less than 2M + 1) $x_1, x_2,..., x_N$, which are provided at equal intervals on a certain line segment or a certain circular arc and which are arranged such that the relation of optical path lengths Lj from respective points $x_j$ to an entrance end surface of the optical fiber is $L_1 > L_2 >...> L_N$, it is preferable to provide the laser diodes such that the centers of the respective active layers at the exit end surfaces of the laser diodes are provided at points $x_1, x_2,..., x_M$, and $x_{N-M+1}, x_{N-M+2},..., x_N$ as in the laser module 1 illustrated in Fig. 1. This is because the maximum intensity of return light, which enters the 2M laser diodes, is the lowest in the above arrangement among $_NC_{2M}$ arrangements in which centers of respective active layers in exit end surfaces of laser diodes are provided at 2M points selected from N points $x_1, x_2,..., x_N$.

[Embodiment 2]

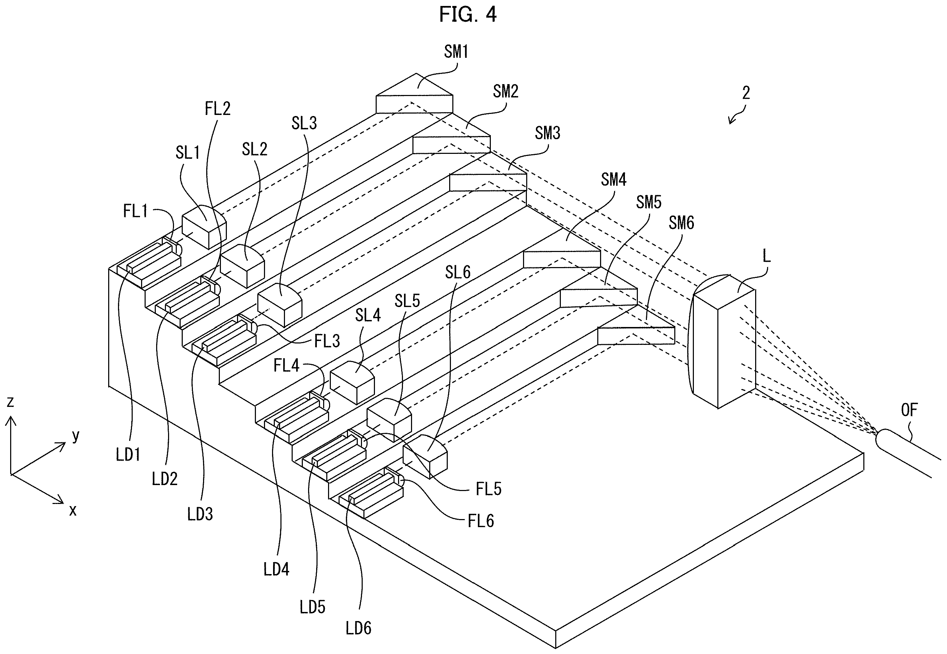

The following will discuss a configuration of a laser module 2 in accordance with Embodiment 2 of the present invention, with reference to Fig. 4. Fig. 4 is a perspective view illustrating a configuration of the laser module 2 in accordance with Embodiment 2.

The laser module 2 includes six laser diodes LD1 to LD6, six F-axis collimating lenses FL1 to FL6, six S-axis collimating lenses SL1 to SL6, six single mirrors SM1 to SM6, a light condensing lens L, and an optical fiber OF, as illustrated in Fig. 4. The laser diodes LD1 to LD6, the F-axis collimating lenses FL1 to FL6, the S-axis collimating lenses SL1 to SL6, the single mirrors SM1 to SM6, and the light condensing lens L are mounted on a bottom plate of a housing of the laser module 1. The optical fiber OF passes through a side wall of the housing of the laser module 1 such that an end portion including an entrance end surface of the optical fiber OF extends into the housing of the laser module 1.

A laser diode LDi (where i is a natural number of not less than 1 and not more than 6) is a light source which emits a laser beam. In Embodiment 2, the laser diode LDi is a laser diode which is arranged such that in a coordinate system illustrated in Fig. 4, an active layer is parallel to an xy plane and an exit end surface is parallel to a zx plane. A laser beam emitted from the laser diode LDi travels in a direction (traveling direction) corresponding to a positive direction of a y axis. The laser beam has a Fast axis (F axis) parallel to a z axis and a Slow axis (S axis) parallel to an x axis. These laser diodes LD1 to LD6 are provided on respective steps of the bottom plate of the housing which bottom plate is arranged to be a step-like plate descending from a negative side to a positive side along the x axis. In this configuration, respective heights (z coordinates) Hi of laser diodes LDi are arranged such that: $H1 > H2 >...> H6$.

An F-axis collimating lens FLi is provided in an optical path of a laser beam emitted from the laser diode LDi. In Embodiment 2, the F-axis collimating lenses FL1 to FL6 are each a plano-convex cylindrical lens which is arranged such that in the coordinate system shown in Fig. 4, a flat surface (entrance face) faces in a negative direction of the y axis and a curved surface (exit face) faces in the positive direction of the y axis. The F-axis collimating lens FLi is arranged so as to have an arc-like outer edge of a cross section parallel to a yz plane on a positive side along the y axis. Then, the F-axis collimating lens FLi collimates the laser beam diverging in an F-axis direction, which laser beam has been emitted from the laser diode LDi.

In an optical path of the laser beam having passed through the F-axis collimating lens FLi, an S-axis collimating lens SLi is provided. In Embodiment 2, the S-axis collimating lenses SL1 to SL6 are each a plano-convex cylindrical lens which is arranged such that in the coordinate system shown in Fig. 4, a flat surface (entrance face) faces in the negative direction of the y axis and a curved surface (exit face) faces in the positive direction of the y axis. The S-axis collimating lens SLi is provided so as to have an arc-like outer edge of a cross section parallel to the xy plane on a positive side along the y axis. Then, the S-axis collimating lens SLi collimates the laser beam diverging in an S-axis direction, which laser beam has been emitted from the laser diode LDi and passed through the F-axis collimating lens FLi.

In an optical path of the laser beam having passed through the S-axis collimating lens SLi, a single mirror SMi is provided. The first mirror DMi1 has the reflective surface whose normal vector is orthogonal to the z axis and whose normal vector makes an angle of 45° with respect to each of a positive direction of the x axis and the negative direction of the y axis. The single mirror SMi reflects a laser beam emitted from the LD chip LDi so as to convert the traveling direction of the laser beam from the positive direction of the y axis to the positive direction of the x axis and also to convert the laser beam from a state in which the S axis is parallel to the x axis to a state in which the S axis is parallel to the y axis. The single mirrors SM1 to SM6 are arranged such that the relation of optical path lengths li from the laser diodes LDi to respectively corresponding single mirrors SMi is: 11 = 12 = 13 = 14 = 15 = 16. Then, respective optical axes of laser beams having been reflected by the single mirrors SM1 to SM6 are parallel to one another in a plane parallel to the zx plane.

In optical paths of the laser beams having been reflected by the single mirrors SM1 to SM6, the light condensing lens L is provided. In Embodiment 2, the light condensing lens L is a plano-convex lens which is arranged such that in the coordinate system shown in Fig. 4, a curved surface (exit face) faces in a negative direction of the x axis and a flat surface (entrance face) faces in the positive direction of the x axis. The light condensing lens L (i) collects the laser beams, which have been reflected by the single mirrors SM1 to SM6, so that optical axes of these light beams intersect with one another at one point and (ii) condenses each of the laser beams so that a diameter of each of the laser beams reduces.

At an intersection of the optical axes of the laser beams having passed through the light condensing lens L, the entrance end surface of the optical fiber OF is provided. The optical fiber OF is provided such that the entrance end surface faces in the negative direction of the x axis. The laser beams each having been condensed by the S-axis light condensing lens SL enter the optical fiber OF via this entrance end surface.

The laser module 2 has a feature in the following point: the laser diodes LD1 to LD6 are spatially clustered so that among light beams constituting return light emitted from the optical fiber OF via the entrance end surface of the optical fiber OF, a light beam on an optical axis (more preferably, paraxial beams) will be prevented from entering the laser diodes LDi via the exit end surfaces of the laser diodes LDi.

In a case where the laser diodes LD1 to LD6 are spatially clustered so that among the return light emitted from the optical fiber, the light beam on the optical axis whose emission angle θ is 0° will be prevented from entering the laser diodes LD1 to LD6, it is possible to decrease the maximum intensity of the return light which enters the laser diodes LD1 to LD6 as compared to that in a conventional laser module 6 (see Fig. 6). This leads to a lower maximum failure occurrence rate of the laser diodes LD1 to LD6 as compared to that in the conventional laser module 6. As a result, the laser module 2 has a longer average device life than the conventional laser module 6.

Further, in a case where the laser diodes LD1 to LD6 are spatially clustered so that among the return light emitted from the optical fiber OF, paraxial beams whose emission angle θ is not more than θ1 will be prevented from entering the laser diodes LD1 to LD6, it is possible to decrease the maximum intensity of the return light which enters the laser diodes LD1 to LD6 to less than half that in the conventional laser module 6 (see Fig. 6). Here, θ1 is given by the above Formula (2). This makes it possible to further decrease the maximum failure occurrence rate of the laser diodes LD1 to LD6 and to consequently, further extend the average device life of the laser module 2.

[Recap]

A laser module (1, 2) in accordance with an embodiment of the present invention includes: a plurality of laser diodes (LD1 to LDn) emitting laser beams; and an optical fiber (OF), the laser beams being caused to enter the optical fiber (OF), the laser diodes (LD1 to LDn) being spatially clustered such that among light beams constituting return light emitted from the optical fiber (OF), a light beam on an optical axis does not meet active layers of the laser diodes (LD1 to LDn) at respective exit end surfaces of the laser diodes (LD1 to LDn), the light beam on the optical axis being emitted at an emission angle of 0°.

The above configuration makes it possible to decrease the maximum intensity of return light which enters the laser diodes (LD1 to LDn) (intensity having the highest value among intensities of the return light which enters the laser diodes (LD1 to LDn), as compared to that in a conventional laser module. This accordingly decreases a maximum failure occurrence rate of the laser diodes (LD1 to LDn) (the highest failure occurrence rate among failure occurrence rates of the laser diodes), as compared to that in the conventional laser module. As a result, the laser module (1, 2) can have a longer average device life than the conventional laser module.

A laser module (1, 2) in accordance with an embodiment of the present invention is preferably configured such that the laser diodes (LD1 to LDn) are spatially clustered such that among light beams constituting return light emitted from the optical fiber (OF), a paraxial beam does not meet active layers of the laser diodes (LD1 to LD6) at respective exit end surfaces of the laser diodes (LD1 to LD6), the paraxial beam having been emitted from the optical fiber (OF) at an emission angle θ of not more than θ1 which is given by the following Formula (A): [Math. 4]

$$\theta_1 = \frac{Arcsin(NA)}{3}\sqrt{2\ln 2} \quad \dots \ (A),$$

where NA is a numerical aperture of the optical fiber.

The above configuration makes it possible to decrease the maximum intensity of return light which enters the laser diodes (LD1 to LDn) to not more than half that of the conventional laser module. This makes it possible to further decrease the maximum failure occurrence rate of the laser diodes (LD1 to LDn) and consequently, to further extend the average device life of the laser module (1, 2).

A laser module (1, 2) in accordance with an embodiment of the present invention is preferably configured such that: the laser diodes (LD1 to LDn) are arranged such that (a) the respective exit end surfaces of the laser diodes (LDi) are provided on a certain line segment or a certain circular arc and (b) a distance between adjacent laser diodes (LDi and LDi+1) which belong to different clusters is larger than a distance between adjacent laser diodes which belong to one cluster.

The above configuration makes it possible to reduce a space required for provision of the laser diodes (LD1 to LD6) as compared to a case where the laser diodes (LD1~LDn) are discretely arranged (e.g., a configuration in which some of the laser diodes are provided on a right side of a light beam on an optical axis while the other laser diodes are provided on a left side of the light beam on the optical axis). As a result, the laser module (1, 2) can have a reduced device size.

A laser module (1, 2) in accordance with an embodiment of the present invention is preferably configured such that: in a case where 2M laser diodes (where M is a natural number of not less than 2) (LD1 to LD2M) are provided, the 2M laser diodes (LD1 to LD2M) are arranged such that centers of the respective exit end surfaces of the laser diodes (LDi) are provided at 2M points $x_1$, $x_2$,..., $x_M$, and $X_{N-M+1}$, $x_{N-M+2}$,..., $x_N$ selected from among N points $x_1$, $x_2$,..., $x_N$, where N is a natural number of not less than 2M + 1, the N points $x_1$, $x_2$,..., $x_N$ being provided at equal intervals on the certain line segment or the certain circular arc and arranged such that a relation of optical path lengths $L_j$ from respective points $x_j$ to an entrance end surface of the optical fiber (OF) is $L_1 > L_2 >...> L_N$.

The maximum intensity of return light which enters the 2M laser diodes (LD1 to LD2M) is the lowest in the above arrangement among $_NC_{2M}$ arrangements in

each of which the centers of the respective exit end surfaces of the laser diodes (LDi) are provided at 2M points selected from the N points $x_1$, $x_2$,..., $x_N$. In other words, the above configuration can extend the average device life of the laser module (1, 2) as compared to a case employing any of other arrangements.

A laser module (1, 2) in accordance with an embodiment of the present invention is preferably configured such that: in a case where 2M - 1 laser diodes (where M is a natural number of not less than 2) (LD1 to LD2M-1) are provided, the 2M-1 laser diodes (LD1 to LD2M-1) are arranged such that centers of the respective exit end surfaces of the laser diodes (LDi) are provided at 2M - 1 points $x_1$, $x_2$,..., $x_M$, and $x_{N-M+2}$, $x_{N-M+3}$,..., $x_N$ selected from among N points $x_1$, $x_2$,..., $x_N$, where N is a natural number of not less than 2M + 1, the N points $x_1$, $x_2$,..., $x_N$ being provided at equal intervals on the certain line segment or the certain circular arc and arranged such that a relation of optical path lengths $L_j$ from respective points $x_j$ to an entrance end surface of the optical fiber (OF) is $L_1 > L_2 >...> L_N$.

The maximum intensity of return light which enters the 2M - 1 laser diodes (LD1 to LD2M-1) is the lowest in the above arrangement among $_NC_{2M-1}$ arrangements in each of which the centers of the respective exit end surfaces of the laser diodes (LDi) are provided at 2M - 1 points selected from the N points $x_1$, $x_2$,..., $x_N$. In other words, the above configuration can extend the average device life of the laser module (1, 2) as compared to a case employing any of other arrangements.

A laser module (1, 2) in accordance with an embodiment of the present invention includes: a plurality of laser diodes (LD1 to LDn) emitting laser beams; and an optical fiber (OF), the laser beams being caused to enter the optical fiber (OF), the laser diodes (LD1 to LDn) being arranged such that among light beams constituting return light emitted from the optical fiber (OF), a paraxial beam does not meet active layers of the laser diodes (LDi) at respective exit end surfaces of the laser diodes (LDi), the paraxial beam having been emitted from the optical fiber (OF) at an emission angle θ of not more than θ1 which is given by the following Formula (A): [Math. 5]

$$\theta_1 = \frac{Arcsin(NA)}{3}\sqrt{2\ln 2} \quad \dots \ (A),$$

where NA is a numerical aperture of the optical fiber.

The above configuration makes it possible to decrease the maximum intensity of return light which enters the laser diodes (LD1 to LDn) to not more than half that of the conventional laser module. This can decrease the maximum failure occurrence rate of the laser diodes (LD1 to LDn) as compared to that in the conventional laser module, and consequently, can extend the average device life of the laser module (1, 2) as compared to that of the conventional laser module.

[Additional Remarks]

The present invention is not limited to the embodiments, but can be altered by a skilled person in the art within the scope of the claims. The present invention also encompasses, in its technical scope, any embodiment derived by combining technical means disclosed in differing embodiments.

Reference Signs List

| 1, 2 | laser module |
| LD1 to LD6 | laser diode |
| FL1 to FL6 | F-axis collimating lens |
| SL1 to SL6 | S-axis collimating lens |
| DM1 to DM6 | double mirror |
| SM1 to SM6 | single mirror |
| FL | F-axis light condensing lens |
| SL | S-axis light condensing lens |
| L | light condensing lens |
| OF | optical fiber |

**Claims**

1. A laser module comprising:

a plurality of laser diodes emitting laser beams; and
an optical fiber,
the laser beams being caused to enter the optical fiber,
the laser diodes being arranged such that among light beams constituting return light emitted from the optical fiber, a paraxial beam does not meet active layers of the laser diodes at respective exit end surfaces of the laser diodes, the paraxial beam having been emitted from the optical fiber at an emission angle $\theta$ of not more than $\theta_1$ which is given by the following Formula (A):
[Math. 1]

$$\theta_1 = \frac{Arcsin(NA)}{3}\sqrt{2\ln 2} \quad \ldots (A),$$

where NA is a numerical aperture of the optical fiber.

2. The laser module as set forth in claim 1, wherein: the laser diodes are spatially clustered.

3. The laser module as set forth in claim 1 or 2, wherein:

the laser diodes are arranged such that (a) the respective exit end surfaces of the laser diodes are provided on a certain line segment or a certain circular arc and (b) a distance between adjacent laser diodes which belong to different clusters is larger than a distance between adjacent laser diodes which belong to one cluster.

4. The laser module as set forth in claim 3, wherein:

the laser diodes are 2M laser diodes, where M is a natural number of not less than 2; and
the 2M laser diodes are arranged such that the respective exit end surfaces of the laser diodes are provided at 2M points $x_1$, $x_2$,..., $x_M$, and $x_{N-M+1}$, $x_{N-M+2}$,..., $x_N$ selected from among N points $x_1$, $x_2$,..., $x_N$, where N is a natural number of not less than 2M + 1, the N points $x_1$, $x_2$,..., $x_N$ being provided at equal intervals on the certain line segment or the certain circular arc and arranged such that a relation of optical path lengths Lj from respective points $x_j$ to an entrance end surface of the optical fiber is $L_1 > L_2 >...> L_N$.

5. The laser module as set forth in claim 3, wherein:

the laser diodes are 2M - 1 laser diodes, where M is a natural number of not less than 2; and
the 2M - 1 laser diodes are arranged such that the respective exit end surfaces of the laser diodes are provided at 2M - 1 points $x_1$, $x_2$,..., $x_M$, and $x_{N-M+2}$, $x_{N-M+3}$,..., $x_N$ selected from among N points $x_1$, $x_2$,..., $x_N$, where N is a natural number of not less than 2M + 1, the N points $x_1$, $x_2$,..., $x_N$ being provided at equal intervals on the certain line segment or the certain circular arc and arranged such that a relation of optical path lengths Lj from respective points $x_j$ to an entrance end surface of the optical fiber is $L_1 > L_2 >...> L_N$.

6. A laser module comprising:

2M - 1 laser diodes emitting laser beams, where M is a natural number of not less than 2; and
an optical fiber,
the laser beams being caused to enter the optical fiber,
the 2M - 1 laser diodes being spatially clustered such that among light beams constituting return light emitted from the optical fiber, a light beam on an optical axis does not meet active layers of the 2M - 1 laser diodes at respective exit end surfaces of the 2M - 1 laser diodes, the light beam on the optical axis being emitted at an emission angle of 0°,
the 2M - 1 laser diodes being arranged such that the respective exit end surfaces of the 2M - 1 laser diodes are provided at 2M - 1 points $x_1$, $x_2$,..., $x_M$, and $x_{N-M+2}$, $X_{N-M+3}$,..., $x_N$ selected from among N points $x_1$, $x_2$,..., $x_N$, where N is a natural number of not less than 2M + 1, the N points $x_1$, $x_2$,..., $x_N$ being provided at equal intervals on a certain line segment or a certain circular arc and arranged such that a relation of optical path lengths Lj from respective points $x_j$ to an entrance end surface of the optical fiber is $L_1 > L_2 > ... > L_N$.

FIG. 1

# FIG. 2

（a）

（b）

FIG. 3

FIG. 4

EP 3 544 128 A1

FIG. 5

FIG. 6

EP 3 544 128 A1

**INTERNATIONAL SEARCH REPORT**

International application No.

PCT/JP2017/041308

| A. CLASSIFICATION OF SUBJECT MATTER |
|---|
| Int. Cl. H01S5/022(2006.01)i, G02B6/42(2006.01)i, H01S5/40(2006.01)i |

According to International Patent Classification (IPC) or to both national classification and IPC

| B. FIELDS SEARCHED |
|---|
| Minimum documentation searched (classification system followed by classification symbols) |
| Int. Cl. H01S5/00-5/50 |

Documentation searched other than minimum documentation to the extent that such documents are included in the fields searched
```
Published examined utility model applications of Japan      1922-1996
Published unexamined utility model applications of Japan    1971-2017
Registered utility model specifications of Japan            1996-2017
Published registered utility model applications of Japan    1994-2017
```

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| A | JP 2016-71040 A (USHIO INC.) 09 May 2016, entire text, all drawings & WO 2016/052270A1 | 1-6 |
| A | JP 2004-179607 A (FUJI PHOTO FILM CO., LTD.) 24 June 2004, entire text, all drawings & US 2004/0114648 A1 | 1-6 |
| A | JP 2013-235943 A (THE FURUKAWA ELECTRIC CO., LTD) 21 November 2013, entire text, all drawings & US 2015/0131692 A1 & WO 2013/168445 A1 & CN 204205281 U | 1-6 |

☒ Further documents are listed in the continuation of Box C.          ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| | |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

International application No.

PCT/JP2017/041308

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-126852 A (FUJIKURA LTD.) 07 July 2014, entire text, all drawings & US 2015/0280404 A1 & WO 2014/103451 A1 & EP 2940503 A1 & CN 104704410 A | 1-6 |
| A | WO 2015/133533 A1 (DENSO CORP.) 11 September 2015, entire text, all drawings & JP 2015-167211 A & US 2017/0107966 A1 & DE 112015001095 T | 1-6 |
| A | US 6501781 B1 (ROBERT BOSCH GMBH) 31 December 2002, entire text, all drawings & EP 982818A2 & DE 19838518 A | 1-6 |

Form PCT/ISA/210 (continuation of second sheet) (January 2015)

**REFERENCES CITED IN THE DESCRIPTION**

**Patent documents cited in the description**

- JP 5717714 B
- JP 2013235943 A